(19) Europäisches Patentamt European Patent Office Office européen des brevets

(11) **EP 2 451 082 B1**

(12) **FASCICULE DE BREVET EUROPEEN**

(45) Date de publication et mention de la délivrance du brevet:
**05.06.2013 Bulletin 2013/23**

(51) Int Cl.:
***H03M 1/06*** (2006.01)

(21) Numéro de dépôt: **11187230.5**

(22) Date de dépôt: **31.10.2011**

(54) **Procédé et dispositif de configuration de circuits électriques et/ou électroniques**

Verfahren und Vorrichtung zur Konfiguration von elektrischen und/oder elektronischen Schaltkreisen

Method and device for configuring electric and/or electronic circuits

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.11.2010 FR 1059204**

(43) Date de publication de la demande:
**09.05.2012 Bulletin 2012/19**

(73) Titulaire: **Commissariat à l'Énergie Atomique et aux Énergies Alternatives**
**75015 Paris (FR)**

(72) Inventeur: **Morche, Dominique**
**38240 Meylan (FR)**

(74) Mandataire: **Ilgart, Jean-Christophe et al**
**BREVALEX**
**95 rue d'Amsterdam**
**75378 Paris Cedex 8 (FR)**

(56) Documents cités:
WO-A1-2005/104376     WO-A2-03/021790
US-A- 5 404 143     US-A- 6 118 398
US-A1- 2003 218 477     US-A1- 2007 120 725
US-A1- 2009 243 663     US-B1- 7 301 366
US-B1- 7 541 857

• AHMED I ET AL: "An 11-Bit 45 MS/s Pipelined ADC With Rapid Calibration of DAC Errors in a Multibit Pipeline Stage", IEEE JOURNAL OF SOLID-STATE CIRCUITS, IEEE SERVICE CENTER, PISCATAWAY, NJ, USA, vol. 40, no. 7, 1 juillet 2008 (2008-07-01), pages 1626-1637, XP011229231, ISSN: 0018-9200

EP 2 451 082 B1

## Description

**DOMAINE TECHNIQUE**

L'invention concerne le domaine de la configuration, de l'optimisation et de la réalisation de circuits électriques et/ou électroniques réalisés dans tous types de technologies : silicium (MOS, BiCMOS, SOI, ...), AsGa ou encore à base de nanotubes de carbone. De même, l'invention ne se limite pas aux circuits fonctionnant dans un domaine de fréquences particulier ou réalisés selon un type de conception particulier, et concerne par exemple la réalisation de circuits radiofréquences, analogiques ou encore de circuits mixtes analogique-numérique.

L'invention concerne également la configuration, l'optimisation et la réalisation de circuits faisant appel à des composants électriques et/ou électroniques (résistances, condensateurs, inductances, transistors, ...), ou à des sous-circuits comportant de tels composants, pouvant présenter une dispersion aléatoire de la valeur d'une ou plusieurs de leurs caractéristiques électriques.

L'invention s'applique également à la réalisation de circuits à partir d'éléments électriques et/ou électroniques dont les performances sont dégradées lorsque la différence entre les valeurs réelles de leurs caractéristiques électriques est importante.

L'invention peut avantageusement être mise en oeuvre pour la configuration, l'optimisation et la réalisation de convertisseurs analogique-numérique ou numérique-analogique, de comparateurs, de filtres à capacités commutés, de paires différentielles, ou tout autre circuit électrique et/ou électronique.

**ÉTAT DE LA TECHNIQUE ANTÉRIEURE**

Deux composants électriques et/ou électroniques, par exemple des résistances, de valeurs nominales identiques ont en réalité des valeurs qui ne sont pas tout à fait identiques. Par exemple, dans le cas de deux résistances électriques de valeurs nominales identiques égales à R Ohms, ces deux résistances ont en réalité chacune une valeur égale à R Ohms +/- quelques % de la valeur de R Ohms, ce pourcentage variant d'une résistance électrique à l'autre.

Cette dispersion autour de la valeur nominale du composant est due aux tolérances de fabrication du composant. Ainsi, lorsque l'on souhaite utiliser, dans un circuit électrique et/ou électronique, deux (ou plus) composants électriques et/ou électroniques de valeurs identiques ou présentant un rapport de valeurs précis, il y a donc de très fortes chances que ces valeurs soient affectées d'une différence, appelée « mismatch » et dont la valeur est aléatoire, due aux aléas de fabrication des composants.

Il existe plusieurs techniques pour réduire l'influence de cette dispersion aléatoire sur les valeurs des caractéristiques électriques des composants, comme divulgué, par exemple, dans les documents WO 2005/104376 A1, US 6 118 398 A, US 7 301 366 B1, US 7 541 857 B1, US 2009/243663 A1, US 2003/218477 A1, US 2007/120725 A1, Ahmed I. et al. : "An 11-Bit 45 MS/s Pipelined ADC With Rapid Calibration of DAC Errors in a Multibit Pipeline Stage", IEEE JOURNAL OF SOLID-STATE CIRCUITS, IEEE SERVICE CENTER, PISCATAWAY, NJ, USA, vol. 40, no. 7, 1 Juillet 2008 (2008-07-01), pages 1626-1637, et WO 03/021790 A2.

La solution la plus simple pour réduire cette dispersion aléatoire consiste à augmenter la taille des composants utilisés afin d'améliorer la précision sur les valeurs réelles des caractéristiques électriques de ces composants. Par exemple, il est connu que la précision des composants fabriqués en technologie silicium est proportionnelle à la surface de ces composants.

Cette solution, bien que performante, a toutefois pour inconvénients d'augmenter la surface du circuit (et donc son coût de réalisation) mais également sa consommation électrique, un courant électrique plus important étant par exemple nécessaire pour charger un condensateur de taille plus importante.

Il est également connu, dans le cas de convertisseurs analogique-numérique ou à codage sigma-delta, de réduire l'influence de la dispersion autour des valeurs des capacités électriques de ces convertisseurs par une compensation numérique ou analogique du signal obtenu en sortie du convertisseur.

Pour cela, on effectue une mesure des performances du convertisseur à partir de signaux connus ou non appliqués en entrée du convertisseur, ou à partir de signaux intermédiaires de test. Ensuite, à partir de mesures réalisées en sortie du convertisseur ou dans le convertisseur, on en déduit une estimation des valeurs des composants utilisés et on corrige la valeur obtenue en sortie du convertisseur à partir d'un circuit, par exemple numérique. L'affinement de la valeur estimée peut se faire de façon itérative ou non.

Cette technique de compensation présente toutefois un certain nombre d'inconvénients. En effet, le calcul de l'estimation des valeurs de chacun des composants est généralement complexe et implique une augmentation de la surface nécessaire et de la consommation électrique. De plus, étant donné que ces circuits présentent généralement d'autres imperfections (non-linéarités, offset, injections de charges parasites, ...), l'estimation des dispersions est souvent affectée d'une erreur et donc limitée en précision.

Le gain en résolution obtenu est donc limité. Enfin, les erreurs générées par les dispersions peuvent avoir parfois des conséquences sur le signal de sortie du convertisseur qui sont irréversibles, comme par exemple une saturation du signal, et qui sont donc impossibles à corriger en sortie du convertisseur par une compensation ultérieure à la conversion du signal par le convertisseur.

Dans certains systèmes tels que les convertisseurs analogique-numérique ou numérique-analogique, il est possible de réduire l'influence de l'imprécision des valeurs des composants en faisant varier au cours du temps l'erreur générée par cette imprécision de façon aléatoire ou déterministe.

Cette variation de l'erreur est utilisée généralement lorsque le nombre de composants identiques utilisés est élevé. Le principe de cette solution est de sélectionner, à chaque instant, de façon aléatoire ou déterministe, un certain nombre de composants nécessaires pour le circuit parmi un nombre plus important de composants disponibles.

Là encore, cette technique, appelée brassage, présente des inconvénients. Tout d'abord, elle n'est applicable qu'à un nombre limité de circuits, à savoir les circuits présentant non seulement un grand nombre de composants mais aussi dont la variation de l'erreur générée permet d'en réduire l'impact. Par exemple, cette technique de brassage ne peut pas toujours être utilisée dans un convertisseur numérique-analogique fonctionnant à la fréquence de Nyquist (dont toute la bande est utilisée dans l'application) car ce brassage aléatoire transforme la non-linéarité en bruit, ce qui n'est pas acceptable car la mise en forme de bruit ne peut être utilisée que si l'on dispose d'un facteur de sur-échantillonnage, ce qui n'est pas toujours le cas dans un tel circuit.

**EXPOSÉ DE L'INVENTION**

Un but de la présente invention est de proposer un procédé et un dispositif de configuration de circuits électriques et/ou électroniques permettant de réduire l'influence de la dispersion autour des valeurs des caractéristiques de composants électriques et/ou électroniques réalisés à partir d'éléments de ces circuits électriques et/ou électroniques.

Un but de la présente invention est également d'améliorer la robustesse du circuit vis-à-vis de la précision sur les valeurs des composants électriques et/ou électroniques utilisés, et/ou de réduire l'impact de la dispersion aléatoire des valeurs nominales des composants électriques et/ou électroniques sur les caractéristiques électriques du circuit électrique et/ou électronique que l'on conçoit.

Pour cela, la présente invention propose un procédé de configuration d'un circuit électrique comprenant plusieurs blocs fonctionnels présentant des grandeurs caractéristiques de même nature et dont les valeurs sont proportionnelles les unes par rapport aux autres, les blocs fonctionnels étant réalisés au moyen d'au moins un ensemble d'éléments électriques de même nature et/ou de même valeur nominale théorique et de moyens de couplage desdits éléments électriques entre eux et/ou au reste du circuit électrique selon différentes configurations de couplage, comportant au moins les étapes de :

- mesure d'une valeur d'au moins un paramètre du circuit électrique pour chacune d'un ensemble de configurations de couplage testées,
- sélection, parmi les configurations de couplage testées, d'une configuration pour laquelle la valeur du paramètre mesurée correspond au cas où l'écart entre les valeurs des grandeurs caractéristiques d'au moins une paire de blocs fonctionnels est le plus faible, et
- positionnement des moyens de couplage selon la configuration sélectionnée.

Dans les différentes configurations de couplage, au moins une partie des éléments électriques sont répartis différemment entre au moins deux blocs fonctionnels. Ces éléments électriques peuvent donc passer d'un bloc fonctionnel à l'autre selon la configuration de couplage.

Pour des raisons de clarté, le terme « électrique » sera utilisé dans la suite du document pour désigner l'expression « électrique et/ou électronique ». De plus, bien que le terme « électronique » soit employé, l'invention concerne également la configuration de circuits microélectroniques et/ou nanoélectroniques à partir d'éléments et/ou de composants microélectroniques et/ou nanoélectroniques.

L'invention permet donc, à partir d'un ensemble d'éléments électriques de même valeur nominale théorique, pouvant présenter des dispersions autour des valeurs de leurs caractéristiques électriques, d'améliorer les performances du circuit électrique comportant des blocs fonctionnels obtenus en combinant judicieusement ces éléments électriques, et sélectionner la configuration d'éléments électriques permettant d'obtenir le circuit présentant les meilleures performances possibles et correspondant au cas où l'écart entre les valeurs des grandeurs caractéristiques d'au moins une paire de blocs fonctionnels est le plus faible.

L'invention peut consister à combiner, par exemple grâce à des interrupteurs, plusieurs éléments électriques pour obtenir plusieurs blocs fonctionnels, correspondant par exemple à des composants électriques équivalents, présentant des caractéristiques électriques, ou grandeurs caractéristiques, de valeurs réelles plus proches l'une de l'autre que si chacun de ces blocs était obtenu à partir d'un seul élément réalisé avec la même tolérance de fabrication que les éléments électriques utilisés pour former les composants équivalents. L'invention permet donc, en combinant judicieusement les éléments électriques entre eux, de combiner également leurs tolérances, ce qui permet, en choisissant la meilleure configuration, de compenser et d'équilibrer au mieux les tolérances des éléments électriques, et réduire ainsi la différence, ou « mismatch », entre deux composants que l'on souhaite réaliser avec des valeurs nominales les plus proches possibles.

Ainsi, lors de la conception du circuit, on compare plusieurs combinaisons possibles d'éléments électriques qui peuvent passer d'un bloc fonctionnel à l'autre, correspondant aux différentes configurations de couplage des éléments électriques, en évaluant les performances du système complet obtenu à partir de ces éléments, par exemple en mesurant la différence entre les grandeurs caractéristiques des blocs fonctionnels formés en combinant les éléments électriques. On garde ensuite la meilleure solution obtenue, c'est-à-dire la combinaison d'éléments électriques formant des blocs fonctionnels dont les grandeurs caractéristiques se rapprochent le plus possible l'une de l'autre ou d'un rapport de proportionnalité souhaité.

Il est également possible de choisir, parmi les différents blocs fonctionnels du circuit, un bloc fonctionnel de référence et de choisir la configuration dans laquelle le ou les autres blocs fonctionnels présentent une grandeur caractéristique dont la valeur se rapproche le plus possible de la valeur réelle de ce bloc fonctionnel de référence.

L'invention peut consister notamment à choisir la configuration dans laquelle les courants et/ou les tensions de sortie des blocs fonctionnels ont les valeurs les plus proches les unes des autres.

Le paramètre mesuré du circuit électrique peut être un rapport signal/bruit, ou un niveau de linéarité, ou un niveau d'offset du circuit électrique.

Dans un mode de réalisation avantageux, le paramètre mesuré du circuit électrique peut être l'écart entre les valeurs des grandeurs caractéristiques de ladite paire de blocs fonctionnels.

Les éléments électriques peuvent être des composants électriques correspondant à des résistances et/ou des inductances et/ou des condensateurs et/ou des transistors, ou des dispositifs électriques comportant chacun une pluralité de composants électriques, ces composants pouvant correspondre à des résistances et/ou des inductances et/ou des condensateurs et/ou des transistors.

Le circuit électrique peut comporter au moins un convertisseur analogique-numérique et/ou un convertisseur numérique-analogique et/ou un comparateur et/ou un amplificateur et/ou un filtre à capacités commutés et/ou une paire différentielle de transistors.

Au moins une partie des configurations de couplage peuvent être obtenues en inversant le signe d'au moins un signal d'entrée et/ou de sortie d'au moins un des éléments électriques.

Les moyens de couplage peuvent être aptes à relier électriquement entre eux, en série et/ou en parallèle, les éléments électriques faisant partie d'un même bloc fonctionnel.

Pour chaque configuration de couplage, ledit ensemble d'éléments électriques peut être choisi parmi une pluralité d'éléments électriques.

Ainsi, le procédé de configuration selon l'invention peut également faire appel au principe de la redondance, permettant ainsi d'augmenter le nombre de configurations et donc, potentiellement, de réduire encore plus la différence entre les valeurs des grandeurs caractéristiques des blocs fonctionnels que l'on cherche à réaliser.

La mesure du paramètre du circuit électrique peut être réalisée en appliquant un signal connu en entrée des blocs fonctionnels formés pour chacune des configurations et en mesurant au moins une caractéristique de sortie desdits blocs fonctionnels. Il est également possible de ne pas calculer directement les valeurs des grandeurs caractéristiques, mais de vérifier qu'elles sont bien appairées.

L'invention concerne également un procédé de réalisation d'un circuit électrique comportant au moins les étapes de :

- réalisation d'un ensemble d'éléments électriques de nature similaire et de moyens de couplage desdits éléments électriques entre eux et/ou au reste du circuit électrique selon différentes configurations de couplage,
- mise en oeuvre d'un procédé de configuration du circuit électrique tel que décrit précédemment.

L'invention concerne également un dispositif de configuration d'un circuit électrique comportant au moins :

- un ensemble d'éléments électriques de nature similaire et/ou de même valeur nominale théorique,
- des moyens de couplage desdits éléments électriques entre eux et/ou au reste du circuit selon différentes configurations de couplage formant plusieurs blocs fonctionnels présentant des grandeurs caractéristiques de même nature dont les valeurs sont proportionnelles les unes par rapport aux autre et dans lesquelles au moins une partie des éléments électriques sont répartis différemment entre au moins deux blocs fonctionnels,
- des moyens de mesure d'une valeur d'au moins un paramètre du circuit électrique pour chacune d'un ensemble de configurations de couplage testées,
- des moyens de sélection, parmi les configurations de couplage testées, d'une configuration dans laquelle la valeur du paramètre mesurée correspond au cas où l'écart entre les valeurs des grandeurs caractéristiques d'au moins une paire de blocs fonctionnels est le plus faible,

- des moyens de positionnement des moyens de couplage selon la configuration sélectionnée.

Le dispositif peut comporter en outre des moyens d'inversion du signe d'au moins un signal d'entrée et/ou de sortie d'au moins un des éléments électriques.

Les moyens de couplage peuvent comporter des interrupteurs aptes à relier électriquement entre eux, en série et/ou en parallèle, les éléments électriques faisant partie d'un même bloc fonctionnel.

Le dispositif peut comporter une pluralité d'éléments électriques parmi lesquels un ensemble d'éléments électriques sont choisis pour chaque configuration de couplage.

Le dispositif peut comporter en outre des moyens d'application d'un signal connu en entrée des blocs fonctionnels formés pour chacune des configurations et des moyens de mesure d'au moins une caractéristique de sortie desdits blocs fonctionnels.

Le dispositif peut comporter en outre des moyens de commande des moyens de couplage.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1 à 6 représentent des exemples de circuits électriques à partir desquels est mis en oeuvre un procédé de configuration de circuit, objet de la présente invention, selon plusieurs modes de réalisation particuliers,
- la figure 7 représente un dispositif de configuration de circuit électrique, également objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

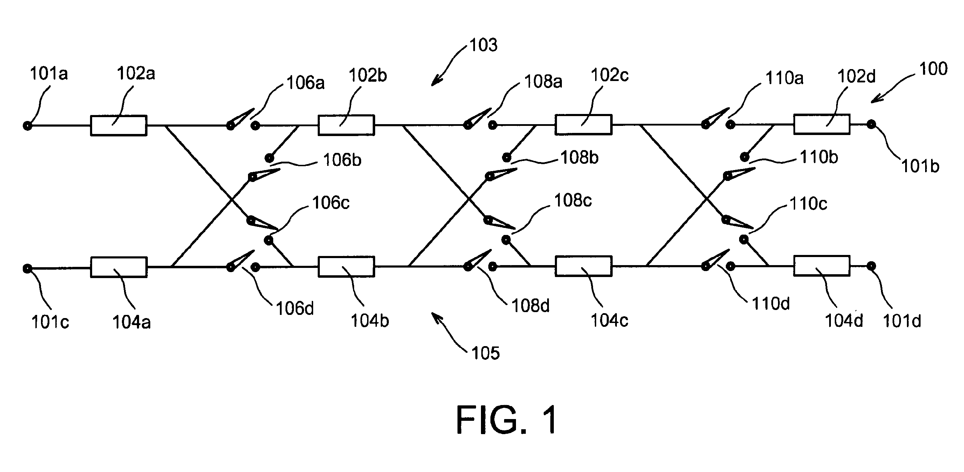

On se réfère tout d'abord à la figure 1 qui représente un exemple de circuit électrique 100 à partir duquel un procédé de configuration de ce circuit est mis en oeuvre selon un mode de réalisation particulier.

A partir du circuit électrique 100, on souhaite réaliser un circuit comportant une première résistance électrique 103 entre les bornes 101a et 101b, et une seconde résistance électrique 105 entre les bornes 101c et 101d. Ces première et seconde résistances électriques 103, 105, formant chacune un bloc fonctionnel dont la grandeur caractéristique correspond à la valeur de la résistance électrique obtenue, vont être réalisées à partir de quatre résistances électriques 102a-102d disposées entre les bornes 101a et 101b, et quatre résistances électriques 104a-104d disposées entre les bornes 101c et 101d.

Etant donné que les résistances 102a, 102d, 104a et 104d comportent chacune une extrémité directement reliée respectivement aux bornes 101a à 101d, les résistances 102a et 102d feront nécessairement partie de la résistance formée entre les bornes 101a et 101b et les résistances 104a et 104d feront nécessairement partie de la résistance formée entre les bornes 101c et 101d.

Le circuit électrique 100 comporte également des moyens de couplage permettant de coupler les résistances 102a-102d et 104a-104d de différentes manières, c'est-à-dire selon différentes configurations.

Ces moyens de couplage sont notamment formés par quatre interrupteurs 106a-106d permettant de coupler de différentes manières les résistances 102a et 104a avec les résistances 102b et 104b.

Ces moyens de couplage comportent également quatre autres interrupteurs 108a-108d permettant de coupler les résistances 102b et 104b avec les résistances 102c et 104c selon différentes configurations. Enfin, les moyens de couplage comportent également quatre autres interrupteurs 110a-110d permettant de coupler les résistances 102c et 104c avec les résistances 102d et 104d selon différentes configurations.

Le tableau ci-dessous donne, en fonction de l'interrupteur fermé, les deux résistances qui se retrouvent reliées électriquement en série.

| Interrupteur fermé | Résistances connectées |
|---|---|
| 106a | 102a et 102b |
| 106b | 104a et 102b |
| 106c | 102a et 104b |
| 106d | 104a et 104b |
| 108a | 102b et 102c |
| 108b | 104b et 102c |
| 108c | 102b et 104c |
| 108d | 104b et 104c |
| 110a | 102c et 102d |
| 110b | 104c et 102d |
| 110c | 102c et 104d |
| 110d | 104c et 104d |

On cherche à réaliser, à partir des résistances électriques 102a-102d et 104a-104d qui ont chacune une même valeur nominale théorique de 500 $\Omega$ , les deux résistances 103 et 105, chacune de valeur théorique égale à 2000 $\Omega$. Toutefois, les résistances électriques ont une valeur réelle qui peut différer de quelques pourcents de leur valeur nominale théorique (dispersion due aux tolérances de fabrication des résistances électriques 102a-102d et 104a-104d).

On cherche donc à réaliser, en combinant judicieusement les résistances 102a-102d et 104a-104d grâce aux moyens de couplage du circuit 100, les deux résistances 103 et 105 telles qu'elles aient des valeurs réelles les plus proches possibles l'une de l'autre.

Le choix de la meilleure combinaison possible, c'est-à-dire de la meilleure configuration permettant d'obtenir des résistances 103 et 105 de valeurs les plus proches possibles, se fera en évaluant les performances obtenues pour les différentes combinaisons, la meilleure solution obtenue étant alors conservée en fermant les interrupteurs adéquates.

Dans le cas présent, l'évaluation des performances consistera à mesurer la résistance électrique présentée par chacune des résistances 103 et 105 pour les différentes configurations.

Si les résistances 102a-102d et 104a-104d ont par exemple les valeurs réelles suivantes :

102a : 505 $\Omega$
102b : 501 $\Omega$
102c : 503 $\Omega$
102d : 499 $\Omega$
104a : 497 $\Omega$
104b : 495 $\Omega$
104c : 502 $\Omega$
104d : 500 $\Omega$

On voit que la meilleure solution consiste à relier les résistances 102a et 102d avec les résistances 104b et 104c en fermant les interrupteurs 106c, 108d et 110b, et à relier les résistances 104a et 104d avec les résistances 102b et 102c en fermant les interrupteurs 106b, 108a et 110c, permettant ainsi d'obtenir deux résistances 103 et 105 chacune de valeur égale à 2001 $\Omega$. Une partie des éléments électriques, ici les résistances 102b, 102c, 104b et 104c, peuvent donc passer d'un bloc fonctionnel à l'autre selon la configuration dans laquelle se trouvent les différents interrupteurs, c'est-à-dire être répartis différemment dans les deux blocs fonctionnels selon la configuration de couplage réalisée.

Le procédé de conception mis en oeuvre à partir du circuit électrique 100 ne consiste donc pas à sélectionner les éléments électriques qui présentent individuellement les valeurs réelles les plus proches de leurs valeurs nominales théoriques respectives, mais à sélectionner et à combiner les composants qui, lorsqu'ils sont combinés, forment un circuit comportant au moins deux blocs fonctionnels, ici les résistances 103 et 105, dont les grandeurs caractéristiques (valeurs réelles des résistances) s'approchent le plus possible l'une de l'autre afin de réduire au minimum l'écart entre les valeurs des grandeurs caractéristiques de ces blocs fonctionnels.

Dans l'exemple précédemment décrit, les composants électriques sont donc sélectionnés et combinés afin d'obtenir deux blocs fonctionnels dont les grandeurs caractéristiques s'approchent le plus possible l'une de l'autre.

Le circuit électrique 100 ne permet pas de réaliser toutes les combinaisons possibles de résistances. On voit par exemple que dans le circuit 100, les résistances 102a et 102d font nécessairement partie de la première résistance 103 et que les résistances 104a et 104d font nécessairement partie de la seconde résistance 105.

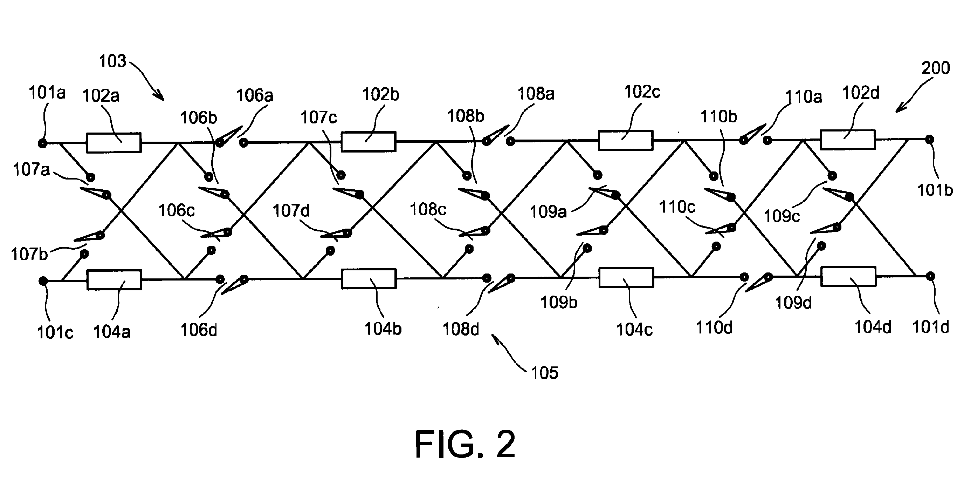

Il est possible d'augmenter le nombre de combinaisons possibles en augmentant le nombre d'interrupteurs dans le circuit électrique. La figure 2 représente un circuit électrique 200 à partir duquel on cherche, de manière analogue au circuit 100, à réaliser un circuit comportant une première résistance électrique 103 entre les bornes 101a et 101b et une seconde résistance électrique 105 entre les bornes 101c et 101d.

Le circuit 200 comporte tous les éléments du circuit électrique 100, c'est-à-dire les résistances 102a-102d et 104a-104d, ainsi que les interrupteurs 106a-106d, 108a-108d et 110a-110d. De plus, le circuit électrique 200 comporte également des interrupteurs supplémentaires 107a-107d et 109a-109d permettant de réaliser toutes les combinaisons possibles entre les résistances 102a-102d et 104a-104d. Ici, tous les éléments électriques, c'est-à-dire toutes les résistances 102a-102d et 104a-104d, peuvent être répartis différemment entre les deux blocs fonctionnels, c'est-à-dire peuvent passer d'un bloc fonctionnel à l'autre, selon la configuration de couplage réalisée.

On voit donc que le circuit 200 permet, par rapport au circuit 100, de réaliser un plus grand nombre de configurations, ce qui peut permettre d'obtenir un meilleur équilibre entre les valeurs des résistances 103 et 105, au prix toutefois d'une complexité plus importante et d'un nombre plus important d'interrupteurs qui peuvent potentiellement influencer la valeur des résistances 103 et 105 obtenues à partir du circuit 200. Ainsi, en fonction des contraintes de réalisation du circuit (fréquence, surface, ...), on choisira de réaliser un circuit offrant plus ou moins de possibilités, c'est-à-dire de combinaisons possibles, et donc plus ou moins d'interrupteurs.

Dans les exemples des circuits 100 et 200 précédemment décrits en liaison avec les figures 1 et 2, on a vu que toutes les résistances 102a-102d et 104a-104d étaient utilisées pour former les deux blocs fonctionnels dont on cherche à équilibrer les grandeurs caractéristiques, c'est-à-dire à équilibrer les valeurs des résistances 103 et 105 formées.

Dans une variante, il est possible que le circuit 100 ou 200 comporte un nombre plus important de résistances électriques, et que parmi toutes ces résistances électriques, seule une partie de celles-ci soit combinées les unes aux autres pour réaliser les résistances 103 et 105, et donc de former la meilleure combinaison possible permettant d'obtenir l'écart minimum entre les valeurs des résistances 103 et 105 obtenues. Ainsi, les circuits 100 et 200 pourraient chacun comporter par exemple douze résistances électriques, chacune de même valeur nominale théorique égale à 500 $\Omega$, et qu'à partir des interrupteurs de ces circuits, seules huit des douze résistances soient utilisées pour former les deux résistances 103 et 105 de valeur nominale théorique égale à 2000 $\Omega$ chacune, les quatre résistances électriques restantes n'étant pas utilisées pour former les résistances 103 et 105. De plus, dans une autre variante, il est possible que l'on cherche à équilibrer les grandeurs caractéristiques de plus de deux blocs fonctionnels, c'est-à-dire que l'on réalise plus de deux résistances dont les valeurs soient le plus proche possible les unes des autres.

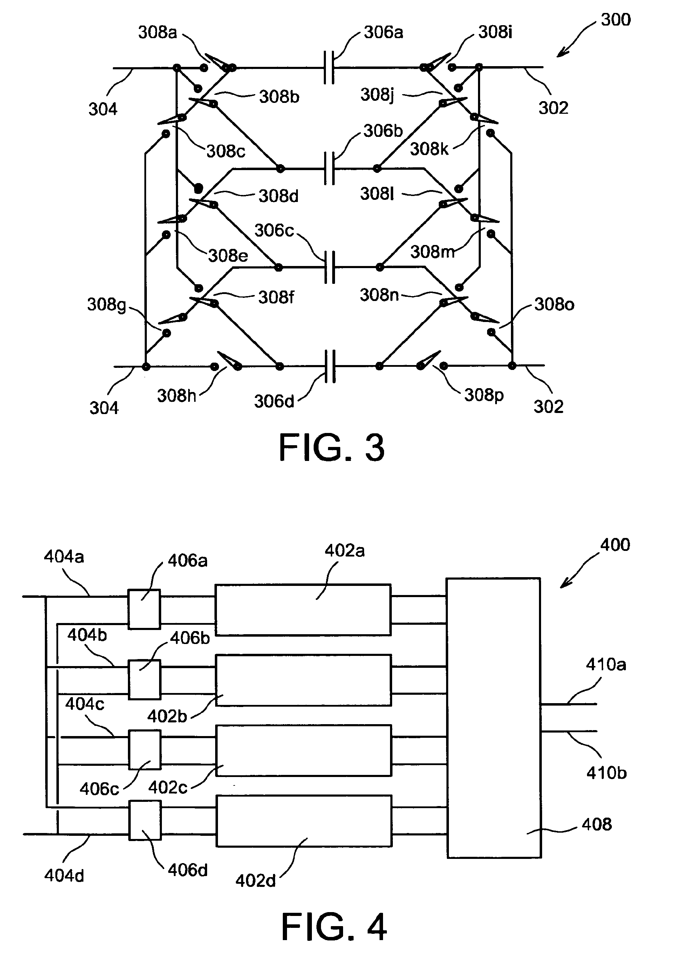

La figure 3 représente un circuit électrique 300 à partir duquel on cherche à relier électriquement en parallèle les condensateurs 306a-306d entre des entrées 302 et des sorties 304 pour former deux blocs fonctionnels, correspondant à deux condensateurs, dont les grandeurs caractéristiques, correspondant aux capacités, aient des valeurs les plus proches possibles l'une de l'autre. Pour cela, le circuit 300 comporte des moyens de couplage des quatre condensateurs 306a-306d comprenant seize interrupteurs 308a-308p. Dans le circuit 300, on cherche donc à réaliser deux blocs fonctionnels de grandeurs caractéristiques les plus proches possible l'une de l'autre, chaque bloc correspondant à une capacité formée par deux des quatre condensateurs 306a-306d reliés en parallèle. Les condensateurs 306a-306d sont répartis différemment entre les deux blocs fonctionnels selon la configuration de couplage réalisée. Le tableau ci-dessous indique les interrupteurs qui se trouvent en position fermée en fonction des deux condensateurs reliés électriquement en parallèle l'un à l'autre.

| Interrupteurs fermés | Condensateurs reliés |
|---|---|
| 308a, 308b, 308g, 308h, 308i, 308j, 308o, 308p | 306a et 306b<br>306c et 306d |
| 308a, 308d, 308e, 308h, 308i, 3081, 308m, 308p | 306a et 306c<br>306b et 306d |
| 308a, 308e, 308f, 308g, 308i, 308m, 308n, 308o | 306a et 306d<br>306b et 306c |

On mesure donc, pour chacune de ces combinaisons, l'écart des valeurs réelles des capacités ainsi formées et on choisit la combinaison dans laquelle l'écart entre les valeurs des deux capacités est le plus faible.

De manière analogue à la variante précédemment décrite en liaison avec les circuits 100 et 200, il est possible que le circuit 300 comporte un nombre plus important de condensateurs et que seule une partie de ces condensateurs soient utilisés pour former les deux capacités que l'on cherche à réaliser, les autres condensateurs n'étant pas reliés au reste du circuit 300. Cette variante permet d'offrir un nombre plus important de combinaisons, et donc d'offrir potentiellement une meilleure configuration.

De plus, dans le cas où le circuit 300 comporte un plus grand nombre de condensateurs, on peut envisager de réaliser plus de deux blocs fonctionnels dont on cherchera à équilibrer les valeurs de leurs grandeurs caractéristiques.

Pour les circuits 100, 200 et 300 précédemment décrits, il est possible que les interrupteurs soient commandés par des signaux de configuration qui, une fois le système évalué et la meilleure combinaison choisie, resteront toujours à la même valeur afin que les éléments choisis restent constamment reliés électriquement dans la configuration choisie.

Toutefois, il est également possible, notamment lorsque les éléments du circuit sont des capacités ou des éléments dynamiques, que les interrupteurs soient utilisés pour remplir une fonction particulière supplémentaire dans le circuit, par exemple pour réaliser la charge et la décharge des condensateurs dans l'exemple du circuit 300.

Il est donc possible que les interrupteurs du circuit soient commandés par des signaux d'horloge.

Les éléments des circuits 100, 200 et 300 précédemment décrits sont des composants électriques et/ou électroniques dont on cherche la meilleure combinaison permettant de réduire la variabilité sur la valeur des éléments obtenus par leur combinaison, c'est-à-dire de réduire l'écart sur les grandeurs caractéristiques des blocs fonctionnels obtenus.

Il est également possible d'appliquer ce principe à un circuit dont les éléments à combiner ne sont pas des composants électriques mais des blocs, ou sous-circuits ou encore dispositifs, formés par plusieurs composants électriques et/ou électroniques et aptes à réaliser des fonctions particulières, par exemple des étages d'amplification ou de conversion de signaux.

Un exemple d'un tel circuit 400 est représenté sur la figure 4. Ce circuit 400 comporte quatre blocs 402a - 402d réalisant chacun une fonction de traitement, par exemple une amplification, identique sur les signaux, par exemple des tensions, appliqués sur des entrées différentielles 404a-404d des blocs 402a-402d. Les quatre blocs 402a-402d présentent donc une même valeur nominale théorique correspondant ici au gain d'amplification. Une même tension d'entrée est appliquée sur les entrées différentielles 404a-404d. Le circuit 400 comporte également quatre ensembles d'interrupteurs 406a-406d permettant d'inverser ou non le signe des signaux appliqués sur les entrées 404a-404d. Un bloc 408 comprend quatre autres ensembles d'interrupteurs permettant d'inverser ou non le signe de chacun des signaux obtenus en sortie des blocs 402a-402d, ces signaux étant sommés et délivrés sur les sorties différentielles 410a, 410b.

Un tel circuit 400 permet, notamment lorsque l'erreur due aux blocs 402a-402d est additive (par exemple un offset dont la valeur est identique quelque soit le signe et la valeur du signal appliqué en entrée d'un des blocs), de réaliser une première inversion par un ou plusieurs des interrupteurs 406a-406d, puis de réaliser une seconde inversion de ces signaux par l'intermédiaire du bloc 408 permettant de retrouver le signe d'origine du signal appliqué en entrée avant de réaliser la sommation des signaux.

Dans l'exemple du circuit 400, on cherche à former un amplificateur de gain nominal égal à 4. Ainsi, si les blocs 402a-402d réalisent chacun une amplification de même gain nominal égal à 1 et que les offsets des blocs 402a-402d sont par exemple égaux à 0,01 pour les blocs 402a et 402c, 0,02 pour le bloc 402b et -0,02 pour le bloc 402d, on pourra réaliser une inversion au niveau de l'interrupteur 406c afin d'obtenir en sortie un gain égal à :

$$(1+0,01)+(1+0,02)-(-1+0,01)+(1-0,02) = 4$$

Par comparaison, si aucune inversion de signe n'est réalisée, on obtient un amplificateur présentant un offset égal à 0,02.

On voit donc qu'une inversion de signe judicieusement choisie des signaux en entrée et en sortie d'un ou plusieurs des blocs 402a - 402d permet de réaliser au moins une configuration dans laquelle l'offset de l'amplificateur est supprimé.

Dans une variante, comme pour les précédents circuits 100, 200 ou 300, il est possible que le circuit 400 comporte un plus grand nombre de blocs 402 et de n'utiliser qu'une partie de ces blocs pour réaliser les configurations du circuit 400.

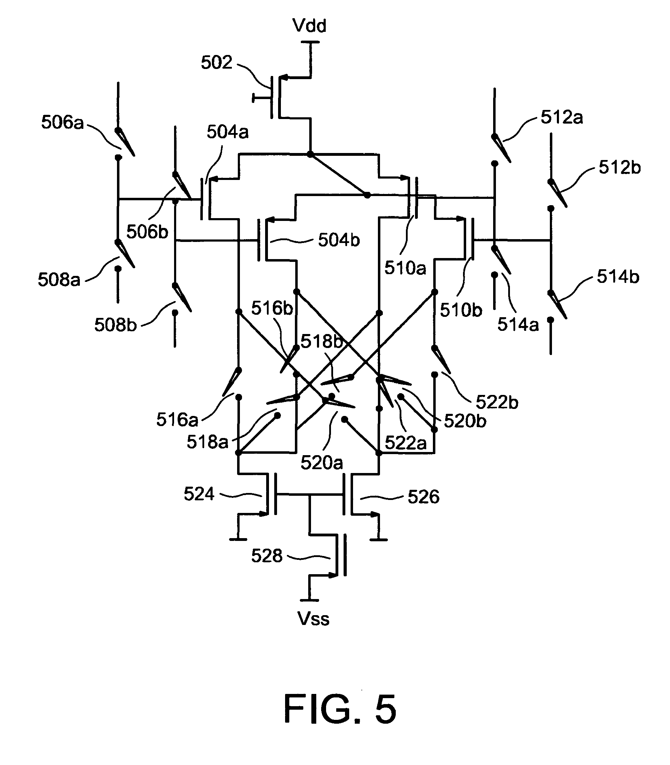

La figure 5 représente un exemple de réalisation d'un des blocs 402a-402d du circuit 400 précédemment décrit en liaison avec la figure 4, formant un circuit composé de deux paires différentielles CMOS.

Ce circuit comporte un premier transistor MOS 502, dont la source est reliée à une tension $V_{DD}$, une tension de commande Vp étant appliquée sur la grille de ce premier transistor 502.

Le drain du premier transistor 502 est relié à la source de deux seconds transistors MOS 504a, 504b dont les grilles sont reliées à deux interrupteurs, respectivement référencés 506a, 506b et 508a, 508b, permettant de relier chacune de ces grilles soit à la composante positive d'un signal d'entrée Vin(t), correspondant au signal appliqué sur les entrées des blocs 402, soit à la composante négative du signal d'entrée Vin(t).

Le drain du premier transistor 502 est également relié à la source de deux troisièmes transistors 510a, 510b dont les grilles sont reliées à une paire d'interrupteurs, respectivement référencés 512a, 512b et 514a, 514b, permettant de relier chacune de ces grilles soit à la composante positive du signal d'entrée Vin(t), soit à la composante négative du signal d'entrée Vin(t).

Le circuit comporte également quatre interrupteurs 516a, 516b, 518a, 518b permettant de relier l'un des drains des transistors 504a, 504b, 510a, 510b au drain d'un quatrième transistor 524. Le bloc comporte également quatre interrupteurs 520a, 520b, 522a, 522b permettant de relier l'un des drains des transistors 504a, 504b, 510a, 510b au drain d'un cinquième transistor 526. Enfin, un sixième transistor 528 est disposé entre les grilles des transistors 524, 526 et une tension $V_{SS}$. La tension de sortie de ce bloc est obtenue de manière différentielle au niveau des drains des transistors 524 et 526.

Dans ce circuit, les différents interrupteurs vont être commutés afin que deux des transistors 504a, 504b, 510a, 510b forment une paire différentielle CMOS couplée aux transistors 524 et 526. Ainsi, un premier bloc fonctionnel peut correspondre au quatrième transistor 524 couplé à l'un des transistors 504a, 504b, 510a, 510b qui sera destiné à recevoir en entrée la composante positive du signal d'entrée Vin(t), et un second bloc fonctionnel peut correspondre au cinquième transistor 526 couplé à l'un des transistors 504a, 504b, 510a, 510b qui sera destiné à recevoir en entrée la composante négative du signal d'entrée Vin(t). Les interrupteurs permettent d'obtenir différentes configurations dans lesquelles deux des quatre transistors 504a, 504b, 510a, 510b sont couplés aux transistors 524 et 526 pour former le circuit d'amplification de gain nominal égal à 1. Parmi ces différentes configurations, on choisira celle dans laquelle les deux blocs fonctionnels présentent des propriétés les plus proches possibles l'une de l'autre. Dans le cas présent, ces propriétés dont on cherche à minimiser l'écart correspondent aux couples (Vt, gm) des transistors de ces blocs fonctionnels, car la minimisation de l'écart entre ces caractéristiques des deux blocs permet de réduire de l'offset obtenu en sortie de ce circuit.

Dans une variante, les interrupteurs 516a, 516b, 518a, 518b, 520a, 520b, 522a, 522b pourraient être remplacés par des transistors utilisés en tant que transistors cascodes reliés à la source de courant formée par les transistors 524 et 526, ce qui permettrait de réduire le nombre d'interrupteurs dans ce circuit et leur impact sur les caractéristiques électriques des amplificateurs opérationnels réalisés.

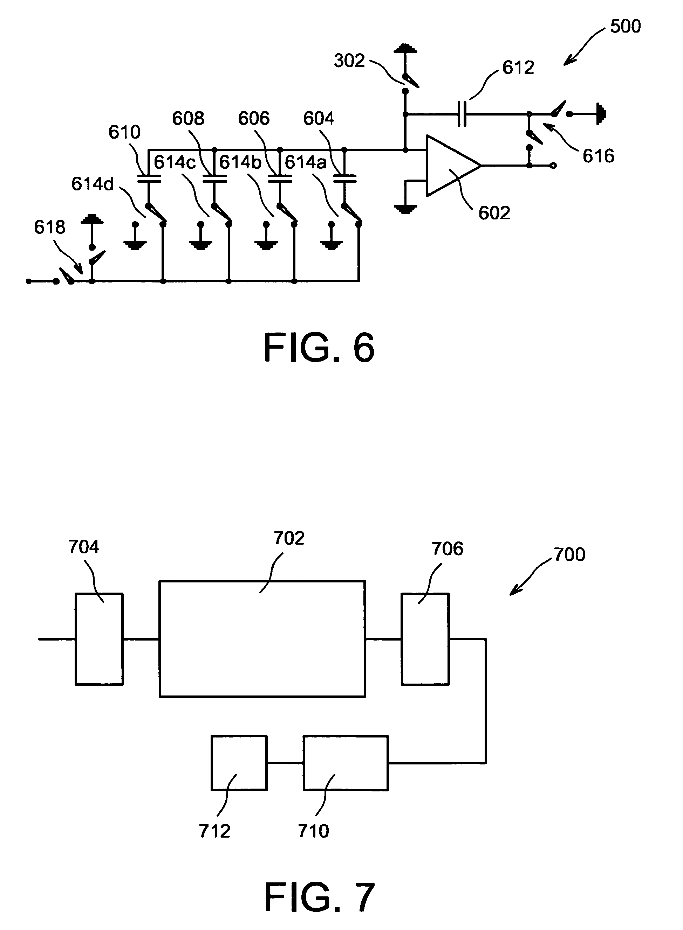

On se réfère maintenant à la figure 6 qui représente un convertisseur numérique-analogique 500 à redistribution de charges comportant un amplificateur opérationnel 602 ainsi que cinq capacités 604, 606, 608, 610 et 612 respectivement de valeurs égales à C, 2C, 4C, 8C et 16C. Ces cinq capacités représentent les blocs fonctionnels du circuit à configurer.

Chacune des capacités 604, 606, 608 et 610 est couplé à un interrupteur 614a - 614d qui permet de relier ou non la capacité qui lui est associée à l'entrée négative de l'amplificateur opérationnel 602.

Ces cinq capacités 604 à 612 sont obtenues à partir d'au moins 31 capacités, par exemple formées par 31 condensateurs, non représentés, et de même valeurs nominales identiques égales à 1C, couplées entre elles en parallèle et qui seront réparties de façon optimale en cinq blocs fonctionnels grâce à des interrupteurs, également non représentés, pour former les cinq capacités 604 à 612. Dans une variante, il est également possible de réaliser ces capacités 604 à 612 à partir de capacités de valeurs nominales identiques différentes de 1C, par exemple 62 capacités chacune de valeur nominale égale à 0,5 C. Les 31 capacités peuvent donc passer d'un bloc fonctionnel à l'autre selon les différentes configurations de couplage envisagées.

On se réfère maintenant à la figure 7 sur laquelle est représenté un dispositif 700 de configuration de circuit électrique selon un mode de réalisation particulier, permettant de mettre en oeuvre un procédé de configuration de circuit tel que décrit précédemment en liaison avec les circuits 100 à 500.

Le dispositif 700 comporte un circuit électrique 702 à configurer. Le circuit 702 comporte par exemple l'un des circuits 100 à 500 précédemment décrits, et comporte notamment un ensemble d'éléments électriques de nature similaire et des moyens de couplage desdits éléments électriques entre eux et/ou au reste du circuit. Ces moyens de couplage permettent de relier les éléments électriques selon différentes configurations de couplage formant, au sein du circuit 702, plusieurs blocs fonctionnels présentant des grandeurs caractéristiques de même nature et dont les valeurs sont proportionnelles les unes par rapport aux autres.

Le dispositif 700 comporte également des moyens 704 permettant d'appliquer un ou plusieurs signaux en entrée du circuit 702, ainsi que des moyens de mesure 706 permettant de mesurer une valeur d'au moins un paramètre du circuit électrique 702 pour chacune des configurations de couplage testées. Les caractéristiques du ou des signaux appliqués en entrée du circuit 702 seront choisies en fonction de la nature du circuit 702, ce signal étant par exemple une rampe, un échelon, une sinusoïde, etc. Les moyens de mesure 706 peuvent mesurer des signaux électriques obtenus en sortie du circuit 702, mais également des caractéristiques propres au circuit 702, par exemple les résistances électriques des blocs fonctionnels si le circuit 702 est similaire aux circuits 100 et 200 précédemment décrits.

Des moyens 710 permettent ensuite de sélectionner, parmi les différentes configurations, celle pour laquelle la valeur du paramètre mesurée correspond au cas où l'écart entre les valeurs des grandeurs caractéristiques d'au moins une paire de blocs fonctionnels est le plus faible.

A partir de la sélection réalisée par les moyens 710, des moyens de positionnement 712 permettent de commuter les moyens de couplage, par exemple des interrupteurs, des éléments électriques du circuit 702 pour que ces éléments électriques soient reliés entre eux selon la configuration choisie.

**Revendications**

1. Procédé de configuration d'un circuit électrique (100-500) comprenant plusieurs blocs fonctionnels présentant des caractéristiques électriques de même nature et dont les valeurs sont proportionnelles les unes par rapport aux autres, les blocs fonctionnels étant réalisés au moyen d'au moins un ensemble d'éléments électriques de même valeur nominale théorique (102a-102d, 104a-104d, 306a-306d, 402a-402d, 604, 606, 608, 610, 612) et de moyens de couplage (106a-106d, 107a-107d, 108a-108d, 109a-109d, 110a-110d, 308a-308p, 406a-406d, 408) desdits éléments électriques entre eux et/ou au reste du circuit électrique selon différentes configurations de couplage, comportant au moins les étapes de :

   - mesure d'une valeur d'au moins un paramètre du circuit électrique (100-500) pour chacune d'un ensemble de configurations de couplage testées,
   - sélection, parmi les configurations de couplage testées, d'une configuration pour laquelle la valeur du paramètre mesurée correspond au cas où l'écart entre les valeurs des caractéristiques électriques d'au moins une paire de blocs fonctionnels est le plus faible, et
   - positionnement des moyens de couplage selon la configuration sélectionnée,

   **caractérisé en ce que**, pour chacune des configurations de couplage, au moins une partie des éléments électriques sont répartis différemment entre au moins deux blocs fonctionnels par rapport aux autres configurations de couplage.

2. Procédé selon la revendication 1, dans lequel le paramètre mesuré du circuit électrique (100-500) est un rapport signal/bruit, ou un niveau de linéarité, ou un niveau d'offset du circuit électrique (100-500).

3. Procédé selon la revendication 1, dans lequel le paramètre mesuré du circuit électrique est l'écart entre les valeurs des caractéristiques électriques de ladite paire de blocs fonctionnels.

4. Procédé selon l'une des revendications précédentes, dans lequel les éléments électriques sont des composants électriques correspondant à des résistances (102a-102d, 104a-104d) et/ou des inductances et/ou des condensateurs (306a-306d, 604, 606, 608, 610, 612) et/ou des transistors, ou dans lequel les éléments électriques sont des dispositifs électriques (402a-402d) comportant chacun une pluralité de composants électriques.

5. Procédé selon l'une des revendications précédentes, dans lequel le circuit électrique (400-500) comporte au moins un convertisseur analogique-numérique et/ou un convertisseur numérique-analogique et/ou un comparateur et/ou un amplificateur et/ou un filtre à capacités commutés.

6. Procédé selon l'une des revendications précédentes, dans lequel au moins une partie des configurations de couplage sont obtenues en inversant le signe d'au moins un signal d'entrée et/ou de sortie d'au moins un des éléments électriques (402a-402d).

7. Procédé selon l'une des revendications précédentes, dans lequel les moyens de couplage (106a-106d, 107a-107d, 108a-108d, 109a-109d, 110a-110d, 308a-308p) sont aptes à relier électriquement entre eux, en série et/ou en parallèle, les éléments électriques (102a-102d, 104a-104d, 306a-306d) faisant partie d'un même bloc fonctionnel.

8. Procédé selon l'une des revendications précédentes, dans lequel, pour chaque configuration de couplage, ledit ensemble d'éléments électriques (102a-102d, 104a-104d, 306a-306d, 402a-402d, 604, 606, 608, 610, 612) est choisi parmi une pluralité d'éléments électriques.

9. Procédé selon l'une des revendications précédentes, dans lequel la mesure du paramètre du circuit électrique (100-500) est réalisée en appliquant un signal connu en entrée des blocs fonctionnels formés pour chacune des configurations et en mesurant au moins une caractéristique de sortie desdits blocs fonctionnels.

10. Procédé de réalisation d'un circuit électrique (100-500) comportant au moins les étapes de :

- réalisation d'un ensemble d'éléments électriques (102a-102d, 104a-104d, 306a-306d, 402a-402d, 604, 606, 608, 610, 612) de nature similaire et de moyens de couplage (106a-106d, 107a-107d, 108a-108d, 109a-109d, 110a-110d, 308a-308p, 406a-406d, 408) desdits éléments électriques entre eux et/ou au reste du circuit électrique selon différentes configurations de couplage,

- mise en oeuvre d'un procédé de configuration du circuit électrique (100-500) selon l'une des revendications 1 à 9.

11. Dispositif (700) de configuration d'un circuit électrique (100-500, 702) comportant au moins :

- un ensemble d'éléments électriques (102a-102d, 104a-104d, 306a-306d, 402a-402d, 604, 606, 608, 610, 612) de même valeur nominale théorique,
- des moyens de couplage (106a-106d, 107a-107d, 108a-108d, 109a-109d, 110a-110d, 308a-308p, 406a-406d, 408) desdits éléments électriques entre eux et/ou au reste du circuit selon différentes configurations de couplage formant plusieurs blocs fonctionnels présentant des caractéristiques électriques de même nature dont les valeurs sont proportionnelles les unes par rapport aux autres,
- des moyens de mesure (706) d'une valeur d'au moins un paramètre du circuit électrique (100-500, 702) pour chacune d'un ensemble de configurations de couplage testées,
- des moyens de sélection (710), parmi les configurations de couplage testées, d'une configuration pour laquelle la valeur du paramètre mesurée correspond au cas où l'écart entre les valeurs des caractéristiques électriques d'au moins une paire de blocs fonctionnels est le plus faible,
- des moyens de positionnement (712) des moyens de couplage selon la configuration sélectionnée,

**caractérisé en ce que**, pour chacune des configurations de couplage, au moins une partie des éléments électriques sont répartis différemment entre au moins deux blocs fonctionnels par rapport aux autres configurations de couplage.

12. Dispositif selon la revendication 11, dans lequel le paramètre mesuré du circuit électrique (100-500) est un rapport signal/bruit, ou un niveau de linéarité, ou un niveau d'offset du circuit électrique (100-500).

13. Dispositif (700) selon la revendication 11, dans lequel le paramètre mesuré du circuit électrique est l'écart entre les valeurs des caractéristiques électriques de ladite paire de blocs fonctionnels.

14. Dispositif (700) selon l'une des revendications 11 à 13, dans lequel les éléments électriques sont des composants électriques correspondant à des résistances (102a-102d, 104a-104d) et/ou des inductances et/ou des condensateurs (306a-306d, 604, 606, 608, 610, 612) et/ou des transistors, ou dans lequel les éléments électriques sont des dispositifs électriques (402a-402d) comportant chacun une pluralité de composants électriques.

15. Dispositif (700) selon l'une des revendications 11 à 14, dans lequel le circuit électrique (400-500) comporte au moins un convertisseur analogique-numérique et/ou un convertisseur numérique-analogique et/ou un comparateur et/ou un amplificateur et/ou un filtre à capacités commutés.

16. Dispositif (700) selon l'une des revendications 11 à 15, comportant en outre des moyens d'inversion (406a-406d, 408) du signe d'au moins un signal d'entrée et/ou de sortie d'au moins un des éléments électriques.

17. Dispositif (700) selon l'une des revendications 11 à 16, dans lequel les moyens de couplage (106a-106d, 107a-107d, 108a-108d, 109a-109d, 110a-110d, 308a-308p) comportent des interrupteurs aptes à relier électriquement entre eux, en série et/ou en parallèle, les éléments électriques (102a-102d, 104a-104d, 306a-306d) faisant partie d'un même bloc fonctionnel.

18. Dispositif (700) selon l'une des revendications 11 à 17, comportant une pluralité d'éléments électriques parmi lesquels un ensemble d'éléments électriques (102a-102d, 104a-104d, 306a-306d, 402a-402d, 604, 606, 608, 610, 612) sont choisis pour chaque configuration de couplage.

19. Dispositif (700) selon l'une des revendications 11 à 18, comportant en outre des moyens (704) d'application d'un signal connu en entrée des blocs fonctionnels formés pour chacune des configurations et des moyens (706) de mesure d'au moins une caractéristique de sortie desdits blocs fonctionnels.

20. Dispositif (700) selon l'une des revendications 11 à 19, comportant en outre des moyens de commande (712) des moyens de couplage.

**Patentansprüche**

1. Verfahren zur Konfiguration eines elektrischen Schaltkreises (100-500), umfassend mehrere Funktionsblöcke mit elektrischen Merkmalen gleicher Art, deren Werte zueinander proportional sind, wobei die Funktionsblöcke mittels wenigstens einer Gruppe elektrischer Elemente mit gleichem theoretischem Nominalwert (102a-102d, 104a-104d, 306a-306d, 402a-402d, 604, 606, 608, 610, 612) und Mitteln (106a-106d, 107a-107d, 108a-108d, 109a-109d, 110a-110d, 308a-308p, 406a-406d, 408) zur Kopplung der elektrischen Elemente untereinander und/oder mit dem restlichen elektrischen Schaltkreis gemäß unterschiedlichen Kopplungskonfigurationen gebildet werden, umfassend wenigstens die folgenden Schritte:

   - Messung eines Wertes wenigstens eines Parameters des elektrischen Schaltkreises (100-500) für jede aus einer Gruppe geprüfter Kopplungskonfigurationen,
   - innerhalb der geprüften Kopplungskonfigurationen Auswahl einer Konfiguration, bei der der gemessene Wert des Parameters dem Fall entspricht, in dem die Differenz zwischen den Werten der elektrischen Merkmale wenigstens eines Paars von Funktionsblöcken am geringsten ist, und
   - Positionierung der Kopplungsmittel entsprechend der gewählten Konfiguration,

   **dadurch gekennzeichnet, dass** für jede der Kopplungskonfigurationen wenigstens ein Teil der elektrischen Elemente im Vergleich zu den anderen Kopplungskonfigurationen unterschiedlich zwischen wenigstens zwei Funktionsblöcken aufgeteilt wird.

2. Verfahren nach Anspruch 1, wobei der für den elektrischen Schaltkreis (100-500) gemessene Parameter ein Verhältnis Signal/Rauschen, ein Linearitätsniveau oder ein Offsetniveau des elektrischen Schaltkreises (100-500) ist.

3. Verfahren nach Anspruch 1, wobei der für den elektrischen Schaltkreis gemessene Parameter die Differenz zwischen den Werten der elektrischen Merkmale des Paares von Funktionsblöcken ist.

4. Verfahren nach einem der vorangehenden Ansprüche wobei die elektrischen Elemente elektrische Komponenten sind, die Widerständen (102a-102d, 104a-104d) und/oder Induktivitäten und/oder Kondensatoren (306a-306d, 604, 606, 608, 610, 612) und/oder Transistoren entsprechen oder bei dem die elektrischen Elemente elektrische Vorrichtungen (402a-402d) sind, die jeweils eine Mehrzahl elektrischer Komponenten umfassen.

5. Verfahren nach einem der vorangehenden Ansprüche, wobei der elektrische Schaltkreis (400-500) wenigstens einen Analog-Digital-Wandler und/oder einen Digital-Analog-Wandler und/oder einen Vergleicher und/oder einen Verstärker und/oder ein Filter mit geschalteten Kondensatoren umfasst.

6. Verfahren nach einem der vorangehenden Ansprüche, wobei wenigstens ein Teil der Kopplungskonfigurationen durch Umkehren des Vorzeichens wenigstens eines Eingangssignals und/oder Ausgangssignals wenigstens eines elektrischen Elements (402a-402d) erhalten wird.

7. Verfahren nach einem der vorangehenden Ansprüche, wobei die Kopplungsmittel (106a-106d, 107a-107d, 108a-108d, 109a-109d, 110a-110d, 308a-308p) dazu geeignet sind, die elektrischen Elemente (1 02a-102d, 104a-104d, 306a-306d), die Teil desselben Funktionsblocks sind, miteinander in Reihe und/oder parallel elektrisch zu verbinden.

8. Verfahren nach einem der vorangehenden Ansprüche, wobei für jede Kopplungskonfiguration die Gruppe elektrischer Elemente (1 02a-1 02d, 104a-104d, 306a-306d, 402a-402d, 604, 606, 608, 610, 612) aus einer Mehrzahl elektrischer Elemente gewählt wird.

9. Verfahren nach einem der vorangehenden Ansprüche, wobei die Messung des Parameters des elektrischen Schaltkreises (100-500) durch Anwenden eines bekannten Signals am Eingang der für jede der Konfigurationen gebildeten Funktionsblöcke und durch Messen wenigstens eines Ausgangsmerkmals der Funktionsblöcke realisiert wird.

10. Verfahren zur Herstellung eines elektrischen Schaltkreises (100-500), das wenigstens die folgenden Schritte umfasst:

    - Herstellung einer Gruppe ähnlicher elektrischer Elemente (1 02a-1 02d, 104a-104d, 306a-306d, 402a-402d, 604, 606, 608, 610, 612) und der Kopplungsmittel (106a-106d, 107a-107d, 108a-108d, 109a-109d, 110a-110d, 308a-308p, 406a-406d, 408) der elektrischen Elemente untereinander und/oder mit dem restlichen elektrischen Schaltkreis gemäß unterschiedlichen Kopplungskonfigurationen,
- Umsetzung eines Konfigurationsverfahrens für den elektrischen Schaltkreis (100-500) gemäß einem der Ansprüche 1 bis 9.

11. Konfigurationsvorrichtung (700) für einen elektrischen Schaltkreis (100-500, 702), welche wenigstens umfasst:

- eine Gruppe elektrischer Elemente (1 02a-1 02d, 104a-104d, 306a-306d, 402a-402d, 604, 606, 608, 610, 612) mit gleichem theoretischem Nominalwert,
- Mittel (106a-106d, 107a-107d, 108a-108d, 109a-109d, 110a-110d, 308a-308p, 406a-406d, 408) zur Kopplung der elektrischen Elemente untereinander und/oder mit dem restlichen elektrischen Schaltkreis gemäß unterschiedlicher Kopplungskonfigurationen zur Bildung mehrerer Funktionsblöcke, die elektrische Merkmale gleicher Art aufweisen, deren Werte zueinander proportional sind,
- Mittel zur Messung (706) eines Wertes wenigstens eines Parameters des elektrischen Schaltkreises (100-500, 702) für jede aus einer Gruppe geprüfter Kopplungskonfigurationen,
- Mittel zur Auswahl (710) einer Konfiguration unter den geprüften Kopplungskonfigurationen, bei der der für den Parameter gemessene Wert dem Fall entspricht, in dem die Differenz zwischen den Werten der elektrischen Merkmale wenigstens eines Paars von Funktionsblöcken am geringsten ist,
- Positionierungsmittel (712) für die Kopplungsmittel gemäß der gewählten Konfiguration,

**dadurch gekennzeichnet, dass** für jede der Kopplungskonfigurationen im Vergleich zu den anderen Kopplungskonfigurationen wenigstens ein Teil der elektrischen Elemente unterschiedlich auf wenigstens zwei Funktionsblöcke verteilt ist.

12. Vorrichtung nach Anspruch 11,
bei welcher der für den elektrischen Schaltkreis (100-500) gemessene Parameter ein Verhältnis Signal/Rauschen oder ein Linearitätsniveau oder ein Offsetniveau des elektrischen Schaltkreises (100-500) ist.

13. Vorrichtung (700) nach Anspruch 11, wobei der für den elektrischen Schaltkreis gemessene Parameter die Differenz zwischen den Werten der elektrischen Merkmale des Paars Funktionsblöcke ist.

14. Vorrichtung (700) nach einem der Ansprüche 11 bis 13, wobei die elektrischen Elemente elektrische Komponenten sind, die Widerständen (102a-102d, 104a-104d) und/oder Induktivitäten und/oder Kondensatoren (306a-306d, 604, 606, 608, 610, 612) und/oder Transistoren entsprechen oder bei dem die elektrischen Elemente elektrische Vorrichtungen (402a-402d) sind, die jeweils eine Mehrzahl elektrischer Komponenten umfassen.

15. Vorrichtung (700) nach einem der Ansprüche 11 bis 14, wobei der elektrische Schaltkreis (400-500) wenigstens einen Analog-Digital-Wandler und/oder einen Digital-Analog-Wandler und/oder einen Vergleicher und/oder einen Verstärker und/oder ein Filter mit geschalteten Kondensatoren umfasst.

16. Vorrichtung (700) nach einem der Ansprüche 11 bis 15, welche ferner Mittel (406a-406d, 408) zur Umkehrung des Vorzeichens wenigstens eines Eingangssignals und/oder Ausgangssignals für wenigstens eines der elektrischen Elemente umfasst.

17. Vorrichtung (700) nach einem der Ansprüche 11 bis 16, wobei die Kopplungsmittel (106a-106d, 107a-107d, 108a-108d, 109a-109d, 110a-110d, 308a-308p) Unterbrecher umfassen, die in der Lage sind, die elektrischen Elemente (1 02a-1 02d, 104a-104d, 306a-306d), die Teil desselben Funktionsblocks sind, miteinander in Reihe und/oder parallel zu verbinden.

18. Vorrichtung (700) nach einem der Ansprüche 11 bis 17, die eine Mehrzahl elektrischer Elemente umfasst, aus denen für jede Kopplungskonfiguration eine Gruppe elektrischer Elemente (102a-102d, 104a-104d, 306a-306d, 402a-402d, 604, 606, 608, 610, 612) gewählt ist.

19. Vorrichtung (700) nach einem der Ansprüche 11 bis 18, welche ferner Mittel (704) zur Anwendung eines bekannten Signals am Eingang der für jede der Konfigurationen gebildeten Funktionsblöcke sowie Mittel (706) zum Messen wenigstens eines Ausgangsmerkmals der Funktionsblöcke umfasst.

20. Vorrichtung (700) nach einem der Ansprüche 11 bis 19, welche ferner Steuer-/Regelmittel (712) für die Kopplungsmittel aufweist.

**Claims**

1. Method for configuring an electrical circuit (100-500) comprising several functional blocks having electrical characteristics of the same type and the values whereof are mutually proportional, the functional blocks being formed by means of at least one set of electrical elements of the same theoretical nominal value (102a-102d, 104a-104d, 306a-306d, 402a-402d, 604, 606, 608, 610, 612) and means (106a-106d, 107a-107d, 108a-108d, 109a-109d, 110a-110d, 308a-308p, 406a-406d, 408) for connecting said electrical elements to one another and/or to the rest of the electrical circuit according to different connection configurations, comprising at least the steps of:

   - measuring a value of at least one parameter of the electrical circuit (100-500) for each of a set of connection configurations tested,
   - selection, from among the connection configurations tested, of one configuration for which the value of the parameter measured corresponds to the case where the mismatch between the values of the electrical characteristics of at least one pair of functional blocks is the smallest, and
   - positioning the connecting means according to the selected connection configuration,

   **characterized in that**, for each of the connection configurations, at least part of the electrical elements are distributed differently between at least two functional blocks compared to the others connection configurations.

2. Method according to claim 1, wherein the measured parameter of the electrical circuit (100-500) is a signal-to-noise ratio, or a linearity level, or an offset level of the electrical circuit (100-500).

3. Method according to claim 1, wherein the measured parameter of the electrical circuit is the mismatch between the values of the electrical characteristics of said pair of functional blocks.

4. Method according to one of the previous claims, wherein the electrical elements are electrical components corresponding to resistors (102a-102d, 104a-104d) and/or inductors and/or capacitors (306a-306d, 604, 606, 608, 610, 612) and/or transistors, or wherein the electrical elements are electrical devices (402a-402d) each including a plurality of electrical components.

5. Method according to one of the previous claims, wherein the electrical circuit (400-500) includes at least one analog-to-digital converter and/or one digital-to-analog converter and/or one comparator and/or one amplifier and/or one switched-capacitor filter.

6. Method according to one of the previous claims, wherein at least part of the connection configurations are obtained by inverting the sign of at least one input and/or output signal of at least one of the electrical elements (402a-402d).

7. Method according to one of the previous claims, wherein the connecting means (106a-106d, 107a-107d, 108a-108d, 109a-109d, 110a-110d, 308a-308p) are capable of electrically interconnecting, in series and/or in parallel, the electrical elements (102a-102d, 104a-104d, 306a-306d) belonging to a same functional block.

8. Method according to one of the previous claims, wherein, for each connection configuration, said set of electrical elements (102a-102d, 104a-104d, 306a-306d, 402a-402d, 604, 606, 608, 610, 612) is selected from among a plurality of electrical elements.

9. Method according to one of the previous claims wherein the measurement of the parameter of the electrical circuit (100-500) is performed by applying a known signal to the input of the functional blocks formed for each of the configurations and measuring at least one output characteristic of said functional blocks.

10. Method for manufacturing an electrical circuit (100-500) comprising at least the steps of:

    - making of a set of electrical elements (102a-102d, 104a-104d, 306a-306d, 402a-402d, 604, 606, 608, 610, 612) of similar type and means (106a-106d, 107a-107d, 108a-108d, 109a-109d, 110a-110d, 308a-308p, 406a-406d, 408) for connecting said electrical elements to one another and/or to the rest of the electrical circuit according to different connection configurations,
    - implementing a method for configuring the electrical circuit (100-500) according to one of claims 1 to 9.

11. Device (700) for configuring an electrical circuit (100-500, 702) comprising at least:

- a set of electrical elements (102a-102d, 104a-104d, 306a-306d, 402a-402d, 604, 606, 608, 610, 612) with the same theoretical nominal value,
- means (106a-106d, 107a-107d, 108a-108d, 109a-109d, 110a-110d, 308a-308p, 406a-406d, 408) for connecting said electrical elements to one another and/or to the rest of the circuit according to different connection configurations forming several functional blocks having electrical characteristics of the same type, the values whereof are mutually proportional,
- means (706) for measuring the value of at least one parameter of the electrical circuit (100-500, 702) for each of a set of tested connection configurations,
- means (710) for selecting, among the tested connection configurations, one configuration for which the value of the measured parameter corresponds to the case where the mismatch between the values of the electrical characteristics of at least one pair of functional blocks is the smallest,
- means (712) for positioning the connecting means according to the selected configuration, **characterized in that**, for each of the connection configurations, at least part of the electrical elements are distributed differently between at least two functional blocks compared to the others connection configurations.

12. Device according to claim 11, wherein the measured parameter of the electrical circuit (100-500) is a signal-to-noise ratio, or a linearity level, or an offset level of the electrical circuit (100-500).

13. Device (700) according to claim 11, wherein the measured parameter of the electrical circuit is the mismatch between the values of the electrical characteristic of said pair of functional blocks.

14. Device (700) according to one of claims 11 to 13, wherein the electrical elements are electrical components corresponding to resistors (102a-102d, 104a-104d) and/or inductors and/or capacitors (306a-306d, 604, 606, 608, 610, 612) and/or transistors, or wherein the electrical elements are electrical devices (402a-402d) each including a plurality of electrical components.

15. Device (700) according to one of claims 11 to 14, wherein the electrical circuit (400-500) includes at least one analog-to-digital converter and/or one digital-to-analog converter and/or one comparator and/or one amplifier and/or one switched-capacitor filter.

16. Device (700) according to one of claims 11 to 15, also comprising means (406a - 406d, 408) for inverting the sign of at least one input and/or output signal of at least one of the electrical elements.

17. Device (700) according to one of claims 11 to 16, wherein the connecting means (106a-106d, 107a-107d, 108a-108d, 109a-109d, 110a-110d, 308a-308p) comprise switches capable of electrically interconnecting, in series and/or in parallel, the electrical elements (102a-102d, 104a-104d, 306a-306d) belonging to a same functional block.

18. Device (700) according to one of claims 11 to 17, including a plurality of electrical elements among which a set of electrical elements (102a-102d, 104a-104d, 306a-306d, 402a-402d, 604, 606, 608, 610, 612) is chosen for each connection configuration.

19. Device (700) according to one of claims 11 to 18, also comprising means (704) for applying a known signal to the input of the functional blocks formed for each of the configurations and means (706) for measuring at least one output characteristic of said functional blocks.

20. Device (700) according to one of claims 11 to 19, also comprising means (712) for controlling the connecting means.

FIG. 1

FIG. 2

**FIG. 3**

**FIG. 4**

FIG. 5

FIG. 6

FIG. 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005104376 A1
- US 6118398 A
- US 7301366 B1
- US 7541857 B1
- US 2009243663 A1
- US 2003218477 A1
- US 2007120725 A1
- WO 03021790 A2

**Littérature non-brevet citée dans la description**

- An 11-Bit 45 MS/s Pipelined ADC With Rapid Calibration of DAC Errors in a Multibit Pipeline Stage. **AHMED I. et al.** IEEE JOURNAL OF SOLID-STATE CIRCUITS. IEEE SERVICE CENTER, 01 Juillet 2008, vol. 40, 1626-1637